# EUROPÄISCHE PATENTSCHRIFT

(11) **EP 3 521 835 B1**
(45) Veröffentlichungstag und Bekanntmachung des Hinweises auf die Patenterteilung: **16.11.2022**
(21) Anmeldenummer: 19153209.2
(22) Anmeldetag: 23.01.2019
(51) Int. Cl.: G01R 11/04, G01R 11/24, G01R 22/06, G01R 1/04

(54) **ELEKTRIZITÄTSZÄHLER MIT EINEM MIT SCHNAPPVERBINDERN VERSEHENEN KLEMMDECKEL**
ELECTRICITY METER WITH A TERMINAL COVER COMPRISING SNAP-FIT CONNECTIONS
COMPTEUR D'ÉLECTRICITÉ DOTÉ D'UN COUVERCLE DE SERRAGE AVEC DES FIXATIONS PAR ENCLIQUETAGE

(30) Priorität: 31.01.2018 DE 102018102167
(43) Veröffentlichungstag der Anmeldung: 07.08.2019
(73) Patentinhaber: EMH metering GmbH & Co. KG, 19258 Gallin (DE)
(72) Erfinder: Dohse, Holger, 22307 Hamburg (DE)
(74) Vertreter: Hauck Patentanwaltspartnerschaft mbB

(56) Entgegenhaltungen:
- WO-A1-2017/134766
- US-B1- 6 316 932

## Beschreibung

Die Erfindung betrifft einen Elektrizitätszähler mit einem Gehäuse, Anschlussklemmen zum Anschließen an eine elektrische Versorgungsleitung und einem Klemmendeckel, der in einer die Anschlussklemmen abdeckenden, geschlossenen Anordnung an dem Gehäuse befestigt und plombiert werden kann.

Elektrizitätszähler mit derartigen Klemmendeckeln sind von der Installation herkömmlicher Wechselstrom- oder Drehstromzähler in Dreipunktmontage bekannt, die insbesondere in Haushaltszählerschränke eingebaut werden. Die Anschlussklemmen werden mit einem elektrischen Leiter oder mehreren elektrischen Leitern der elektrischen Versorgungsleitung verbunden. Sie befinden sich an einer Unterseite des Elektrizitätszählers. Soweit jetzt und im Folgenden von unten, oben, vorn oder hinten die Rede ist, beziehen sich diese Angaben stets auf die übliche Einbauposition des Elektrizitätszählers beispielsweise in einem Zählerschrank. Um eine unbeabsichtigte Berührung spannungsführender Teile zu verhindern, werden die Anschlussklemmen mit einem Klemmendeckel abgedeckt. Der Klemmendeckel wird in der Regel verplombt. Durch die Verplombung werden eine unbemerkte Manipulation an den Anschlussklemmen des Elektrizitätszählers und eine betrügerische Stromentnahme verhindert, sodass die Interessen des Messstellenbetreibers gewahrt werden.

Die an die Anschlussklemmen anzuschließenden elektrischen Leiter weisen häufig einen großen Querschnitt von beispielsweise 6 mm² bis 16 mm² auf und sind entsprechend inflexibel. Sie können je nach Einbausituation im Betrieb erhebliche Kräfte von unten auf den unteren Rand des Klemmendeckels ausüben. Daher ist eine relativ stabile Befestigung des Klemmendeckels notwendig.

Aus dem Stand der Technik bekannte Klemmendeckel werden mithilfe von Plombierschrauben befestigt. Beispielsweise zeigt die Druckschrift DE 20 2015 104 200 U1 einen Elektrizitätszähler mit einem Klemmendeckel und zwei seitlich angebrachten Plombierschrauben. Die Druckschrift EP 2 539 721 B1 zeigt einen Elektrizitätszähler mit einem Klemmendeckel und einer mittig angebrachten Plombierschraube.

Für Wartungszwecke oder zum Austausch des Elektrizitätszählers kann es erforderlich sein, den Klemmendeckel wieder zu entfernen. Bei den bekannten Zählern müssen hierzu zunächst die Plomben entfernt und nachfolgend die Plombierschrauben herausgeschraubt werden.

Aus der Druckschrift US 6,316,932 B1 ist ein Elektrizitätszähler bekannt geworden, bei dem zwischen Gehäuse und Klemmendeckel eine Rastverbindung vorgesehen ist, die einen Schutz vor Betrugsversuchen bieten soll.

Aus der Druckschrift WO 2017/134766 A1 ist ein Elektrizitätszähler mit den Merkmalen des Oberbegriffs des Anspruchs 1 bekannt geworden.

Davon ausgehend ist es die Aufgabe der Erfindung, einen Elektrizitätszähler zur Verfügung zu stellen, bei dem ein einfacheres Abnehmen und Befestigen des Klemmendeckels möglich ist.

Diese Aufgabe wird gelöst durch den Elektrizitätszähler mit den Merkmalen des Anspruchs 1. Vorteilhafte Ausgestaltungen sind in den Unteransprüchen angegeben.

Der Elektrizitätszähler hat ein Gehäuse, Anschlussklemmen zum Anschließen an eine elektrische Versorgungsleitung und einen Klemmendeckel, der in einer die Anschlussklemmen abdeckenden, geschlossenen Anordnung an dem Gehäuse befestigt und plombiert werden kann, wobei zwischen dem Gehäuse und dem Klemmendeckel eine Rastverbindung vorgesehen ist, die ein Schließen des Klemmendeckels durch Bewegen des Klemmendeckels in einer Schließrichtung in die geschlossene Anordnung ermöglicht, und die Rastverbindung selbstverriegelnd ist, sodass eine auf den Klemmendeckel ausgeübte Kraft in der der Schließrichtung entgegengesetzten Richtung nicht zur Aufhebung der Rastverbindung führt.

Die Anschlussklemmen sind zum Anschließen des Elektrizitätszählers an eine elektrische Versorgungsleitung vorgesehen, d. h. insbesondere zur Verbindung mit mehreren Leitern, die jeweils einen Querschnitt im Bereich von mindestens 1,5 mm² aufweisen.

Die bei der Erfindung vorgesehene Rastverbindung ermöglicht ein sehr einfaches Schließen des Klemmendeckels. Hierzu muss der Klemmendeckel lediglich in einer Schließrichtung in die geschlossene Anordnung bewegt werden. Dies führt zu einem Verrasten miteinander zusammenwirkender Rastelemente der Rastverbindung.

Die auf diese Weise hergestellte Rastverbindung ist selbstverriegelnd. Das bedeutet, dass eine auf den Klemmendeckel in Gegenrichtung zu der Schließrichtung ausgeübte Kraft allein nicht zu einer Aufhebung der Rastverbindung führen kann. Hierzu sind die miteinander zusammenwirkenden Rastelemente der Rastverbindung so ausgeführt, dass sie bei Ausübung einer Kraft in der der Schließrichtung entgegengesetzten Richtung in ihrer verrasteten Stellung verbleiben, gegebenenfalls bis hin zu einer Zerstörung. Auf diese Weise wird eine hinreichend stabile Befestigung des Klemmendeckels in der geschlossenen Anordnung erreicht. Eine zusätzliche Verschraubung des Klemmendeckels ist nicht erforderlich und bei der Erfindung auch nicht vorgesehen. Insbesondere kann auf die im Stand der Technik vorgesehene Befestigung des Klemmendeckels mit Plombierschrauben verzichtet werden.

In einer Ausgestaltung weist der Elektrizitätszähler Entriegelungsmittel zum Aufheben der Rastverbindung auf. Die Entriegelungsmittel können am Gehäuse des Elektrizitätszählers oder am Klemmendeckel ausgebildet sein. Mithilfe der Entriegelungsmittel können zwei miteinander zusammenwirkende Rastelemente der Rastverbindung aus einer verriegelten Stellung in eine entriegelte Stellung überführt werden, sodass der Klemmendeckel nachfolgend in zu der Schließrichtung entgegengesetzter Richtung abgenommen werden kann. Die Entriegelungsmittel können in das Gehäuse bzw. in den Klemmendeckel integriert sein, sodass die Entriegelung ohne zusätzliches Werkzeug gelingt.

In einer Ausgestaltung sind die Entriegelungsmittel dazu ausgebildet, beim Ausüben einer Kraft auf die Entriegelungsmittel quer zur Schließrichtung eine elastische Verformung des Klemmendeckels zu bewirken. Die elastische Verformung des Klemmendeckels hebt zugleich den Eingriff zwischen den miteinander zusammenwirkenden Rastelementen auf. Dabei sind die Entriegelungsmittel so ausgebildet, dass die auszuübende Kraft quer zur Schließrichtung ausgeübt werden muss, etwaige auf den Klemmendeckel von unten ausgeübte Kräfte, insbesondere durch die Anschlusskabel, können zu dieser Entriegelung nichts beitragen.

In einer Ausgestaltung weist die Rastverbindung einen Hinterschnitt am Gehäuse und eine Rastnase am Klemmendeckel auf. In der geschlossenen Anordnung greift die Rastnase in den Hinterschnitt ein und bewirkt so die selbstverriegelnde Rastverbindung.

In einer Ausgestaltung ist am Hinterschnitt und/oder an der Rastnase eine Verriegelungsfläche ausgebildet, die in einem Winkel im Bereich von 80° bis 100° zur Schließrichtung angeordnet ist. Insbesondere kann die Verriegelungsfläche in einem Winkel von etwa 90° zur Schließrichtung angeordnet sein. In dem genannten Winkelbereich führen in der Schließrichtung entgegengesetzter Richtung ausgeübte Kräfte nicht zu der für eine Entriegelung erforderlichen Auslenkung der Rastnase, sodass die selbstverriegelnde Ausprägung der Rastverbindung sehr einfach erzielt wird.

Bei der Erfindung ist der Klemmendeckel kastenförmig mit einer Vorderwand, einer unteren Seitenwand und zwei sich an die untere Seitenwand anschließenden, seitlichen Seitenwänden ausgebildet, die jeweils ein freies Ende aufweisen, an dem ein Steg mit einer Rastnase angeordnet ist. Bei der genannten Geometrie des Klemmendeckels weisen die freien Enden der seitlichen Seitenwände eine relativ große elastische Verformbarkeit auf. Die Ausbildung der Rastnasen an dort angeordneten Stegen macht sich dies zunutze, um die für die Verriegelung und Entriegelung erforderliche Beweglichkeit der Rastnase sicherzustellen. Hierzu können die Rastnasen oder damit zusammenwirkende Gegenstücke am Gehäuse Schrägflächen aufweisen, deren Flächennormalen in einer Ebene angeordnet sind, die im Wesentlichen parallel zu der Ebene der unteren Seitenwand angeordnet ist und/oder deren Flächennormalen im Wesentlichen senkrecht, d. h. zum Beispiel in einem Winkelbereich von 60° bis 120°, zu den seitlichen Seitenwänden ausgerichtet sind.

In einer Ausgestaltung sind die Stege parallel zu der unteren Seitenwand ausgerichtet. Insbesondere können die Stege seitlich einer in einer oberen Seitenwand des kastenförmigen Klemmendeckels befindlichen Öffnung angeordnet sein. Wird der Klemmendeckel dann bestimmungsgemäß so an dem Gehäuse des Elektrizitätszählers angeordnet, dass ein Teil des Gehäuses in der Öffnung angeordnet ist, bewirken die Stege zugleich eine Fixierung des Klemmendeckels in seitlicher Richtung.

In einer Ausgestaltung ist an zwei Seiten des Gehäuses jeweils ein paar von parallel angeordneten Führungsflächen ausgebildet, zwischen denen einer der Stege in der Schließrichtung eingeführt werden kann. Durch diese Führung der Stege wird eine weitere Fixierung des Klemmendeckels quer zur Ebene der Stege erzielt. Zugleich wird verhindert, dass die an den Stegen ausgebildeten Rastnasen bei einer Verschiebung des Klemmendeckels nach oben oder unten aus ihrer verriegelten Stellung gelangen.

In einer Ausgestaltung ist der Hinterschnitt zwischen den Führungsflächen angeordnet. Die Führungsflächen üben ihre Führungswirkung dann insbesondere im Bereich der Rastnasen aus.

In einer Ausgestaltung weisen die Entriegelungsmittel eine von einem der Stege nach außen vorstehende Rippe auf. Die Rippe steht nach außen vor, d. h. sie kann mit einem oder mehreren Fingern ergriffen werden, wenn sich der Klemmendeckel in der geschlossenen Anordnung befindet. Dann kann quer zur Schließrichtung eine Kraft auf die Rippe ausgeübt werden, die insbesondere eine Verformung des Klemmendeckels und eine damit einhergehende Entriegelung der Rastnase bewirkt.

In einer Ausgestaltung weisen die Entriegelungsmittel eine in einem der Stege oder in einer der seitlichen Seitenwände ausgebildete Öffnung auf. Die Öffnung kann insbesondere so bemessen sein, dass mit einem Finger in die Öffnung eingegriffen werden kann, um die Kraft quer zur Schließrichtung auf den Steg bzw. die seitliche Seitenwand auszuüben.

In einer Ausgestaltung sind Plombiermittel zur Plombierung des Klemmendeckels vorgesehen, die keinen wesentlichen Beitrag zur Fixierung des Klemmendeckels in der geschlossenen Anordnung leisten. Wie eingangs erläutert, wird die stabile Fixierung des Klemmendeckels bei der Erfindung durch die selbstverriegelnde Rastverbindung erzielt. Eine zusätzliche Fixierung durch hierfür ausgelegte Plombiermittel, insbesondere durch Plombierschrauben, ist nicht erforderlich. Stattdessen können einfache Plombiermittel eingesetzt werden, die keinen wesentlichen Beitrag zur Fixierung des Klemmendeckels in der geschlossenen Anordnung leisten, sondern lediglich den Nachweis einer Manipulation ermöglichen.

In einer Ausgestaltung sind zur Plombierung des Klemmendeckels Öffnungen im Gehäuse und im Klemmendeckel ausgebildet, die in der geschlossenen Anordnung so zueinander ausgerichtet sind, dass ein Plombierdraht oder ein Plombierstift eingesetzt werden kann. Insbesondere kann am Gehäuse eine Plombierungslasche ausgebildet sein, die in der geschlossenen Anordnung des Klemmendeckels in eine Plombierungsdurchführung am Klemmendeckel eingreift. Ein Plombierdraht kann dann durch zueinander ausgerichtete Öffnungen in der Plombierungsdurchführung und in der Plombierungslasche hindurchgeführt werden. Bei Verwendung eines Plombierstifts insbesondere aus Kunststoff kann der Plombierstift durch die Öffnung im Klemmendeckel in eine zur Verankerung des Plombierstifts geeignete Öffnung im Gehäuse eingesetzt und nachfolgend in an sich bekannter Weise außerhalb des Klemmendeckels mit einer Plombierzange mit einem Siegel versehen werden.

Nachfolgend wird die Erfindung anhand von in Figuren dargestellten Ausführungsbeispielen näher erläutert. Es zeigen:
- Fig. 1: einen Elektrizitätszähler ohne Klemmendeckel in einer perspektivischen Ansicht,
- Fig. 2: einen Klemmendeckel in einer perspektivischen Ansicht,
- Fig. 3: den Elektrizitätszähler aus Fig. 1 mit dem Klemmendeckel aus Fig. 2 in geschlossener Anordnung in einer Draufsicht auf die Vorderseite,
- Fig. 4: eine Querschnittsdarstellung durch die Anordnung aus Fig. 3 entlang der in Fig. 3 gekennzeichneten Schnittebene,
- Fig. 5: einen vergrößerten Ausschnitt aus Fig. 4.

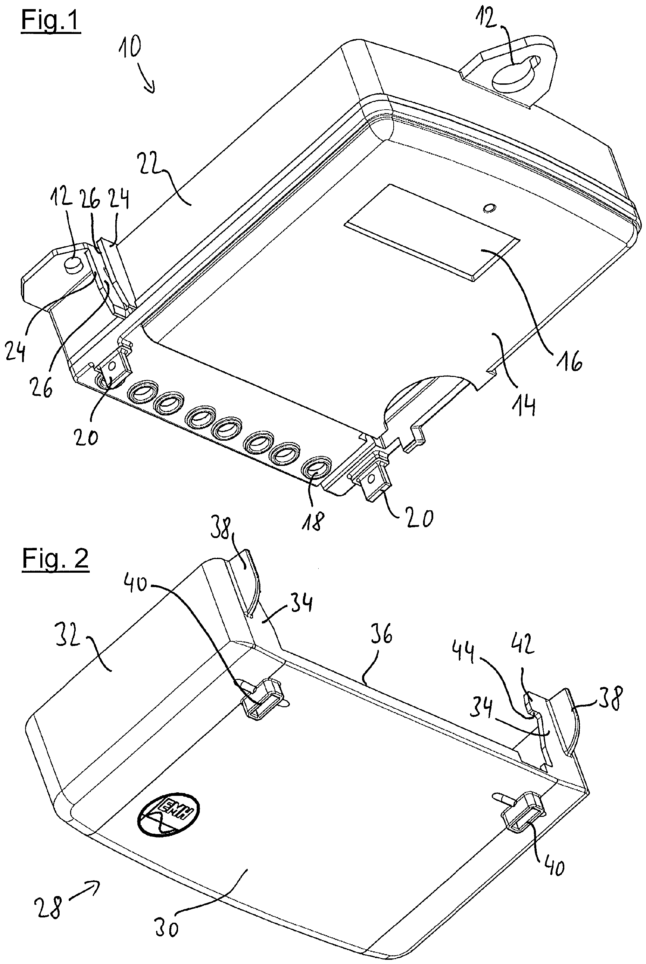

Der Elektrizitätszähler aus Fig. 1 hat ein Gehäuse 10 mit drei Befestigungspunkten 12 zur Befestigung des Elektrizitätszählers beispielsweise in einem Haushaltszählerschrank. In der vorgesehenen Einbauposition ist die Vorderseite 14 des Gehäuses 10, in der eine Anzeigeeinheit 16 angeordnet ist, einem Benutzer zugewandt. Das Gehäuse 10 ist im Wesentlichen quaderförmig. An seinem unteren Ende sind mehrere, in der Fig. 1 nicht sichtbare Anschlussklemmen angeordnet, die mit Anschlusskabeln einer elektrischen Versorgungsleitung verbunden werden. In einer der Anzahl der Anschlussklemmen entsprechenden Anzahl von Öffnungen 18 an der Vorderseite 14 des Gehäuses 10 sind Klemmschrauben zur Fixierung der Anschlusskabel in den Anschlussklemmen angeordnet.

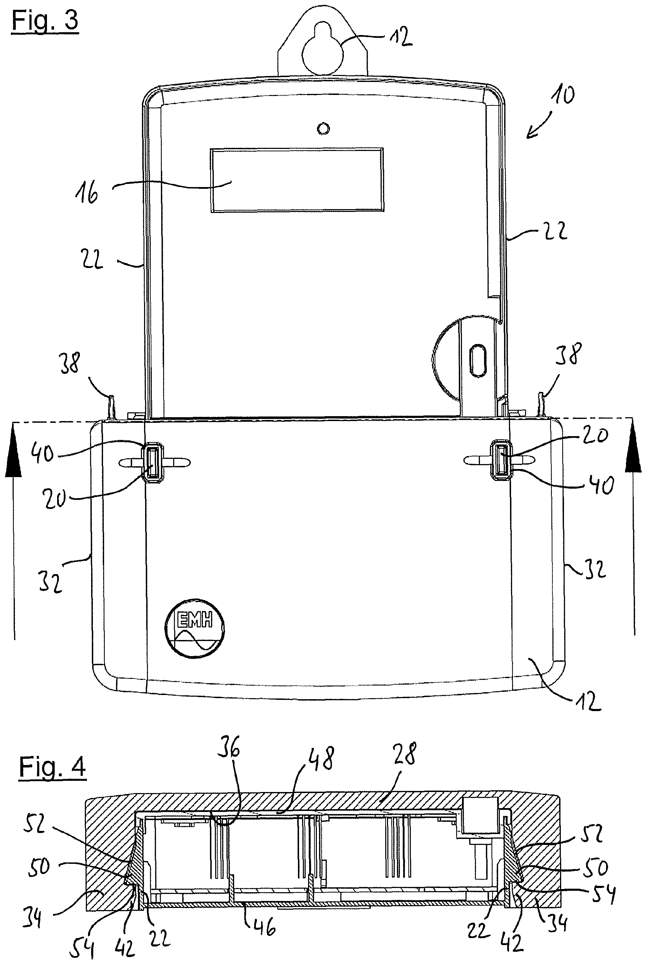

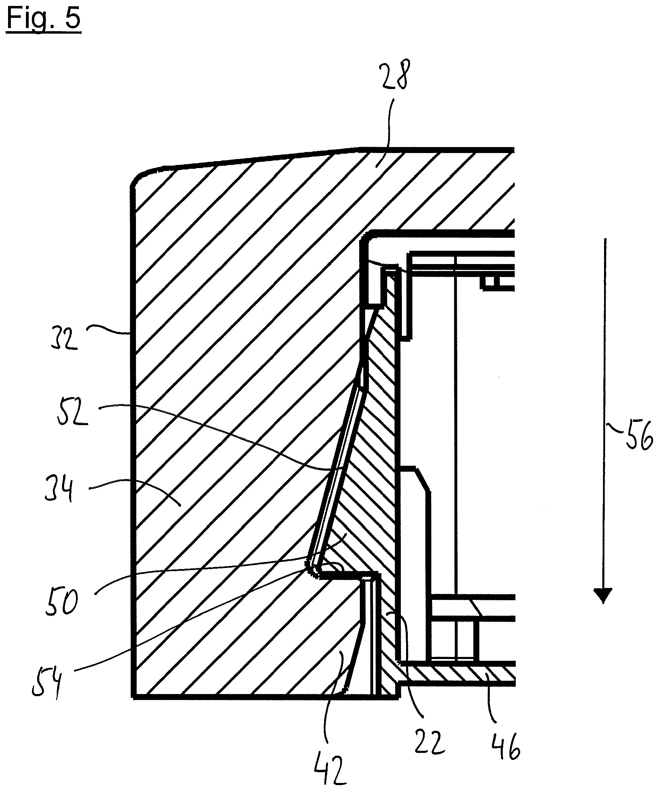

In einem unteren Bereich der Vorderseite 14 des Gehäuses 10 sind an beiden Seiten Plombierungslaschen 20 angeordnet, die jeweils eine Durchgangsöffnung für einen Plombierdraht aufweisen. An jeder der beiden Seitenwände 22 des Gehäuses 10 sind zwei seitlich nach außen weisende Rippen 24 angeordnet, deren einander zugewandte Seiten parallel angeordnete Führungsflächen 26 bilden. Zwischen den parallel angeordneten Führungsflächen 26 weist das Gehäuse 10 jeweils eine Schrägfläche 52 und einen Hinterschnitt 54 auf. Diese Elemente werden später anhand der Figuren 4 und 5 genauer erläutert.

Fig. 2 zeigt einen kastenförmigen Klemmendeckel 28 mit einer Vorderwand 30, einer in Fig. 2 verdeckten unteren Seitenwand und zwei sich seitlich an die untere Seitenwand anschließenden, seitlichen Seitenwänden 32. An den oberen, freien Enden der Seitenwände 32 ist jeweils ein nach innen weisender Steg 34 ausgebildet, der parallel zu der unteren Seitenwand ausgerichtet ist, d. h. sich in einer parallel zu der unteren Seitenwand verlaufenden, gedachten Ebene befindet. In dieser Ebene gibt es außerdem eine Öffnung 36, deren Abmessungen im Wesentlichen dem Querschnitt des Gehäuses 10 des Elektrizitätszählers entsprechen. In der geschlossenen Anordnung des Klemmendeckels 28 nimmt diese Öffnung 36 das Gehäuse 10 des Elektrizitätszählers auf.

Von jedem der beiden Stege 34 steht eine Rippe 38 nach oben vor. Diese Rippen 38 sind parallel zu den seitlichen Seitenwänden 32 ausgerichtet. Bei geschlossener Anordnung des Klemmendeckels 28 weisen die Rippen 38 einen seitlichen Abstand von den Seitenwänden 22 des Gehäuses 10 auf, sodass sie jeweils mit einem Finger an der Innenseite ergriffen und aufgrund der Elastizität des Klemmendeckels 28 nach außen gebogen werden können. An den Stegen 34 ist jeweils eine Rastnase 42 mit einer Verriegelungsfläche 44 angeordnet. Die Verriegelungsfläche 44 ist etwa parallel zur Vorderwand 30 ausgerichtet.

An der Vorderwand 30 des Klemmendeckels 28 ist an beiden Seiten in einem oberen Bereich jeweils eine Plombierungsdurchführung 40 zur Aufnahme einer der Plombierungslaschen 20 angeordnet. Die Plombierungsdurchführungen 40 weisen jeweils zwei voneinander beabstandete Seitenwände mit einer Durchgangsöffnung auf.

Diese Durchgangsöffnungen fluchten bei geschlossener Anordnung des Klemmendeckels 28 mit den Durchgangsöffnungen in den Plombierungslaschen 20, sodass jeweils ein Plombierdraht hindurchgeführt werden kann. Diese Plombierdrähte sichern dann die unter dem Klemmendeckel 28 angeordneten Elemente vor unbefugtem Zugriff, weil sie beim Öffnen des Klemmendeckels 28 beschädigt werden und so ein unbefugtes Öffnen anzeigen. Zur Fixierung des Klemmendeckels 28 am Gehäuse 10 des Elektrizitätszählers tragen sie jedoch nichts Wesentliches bei.

Fig. 3 zeigt den Elektrizitätszähler bei geschlossenem Klemmendeckel 28. Gut erkennbar sind die von den Seitenwänden 22 des Gehäuses 10 des Elektrizitätszählers beabstandeten Rippen 28, die einfach mit jeweils einem Finger nach außen gebogen werden können. Dadurch können die freien Enden der seitlichen Seitenwände 32 des Klemmendeckels 28 mit den Stegen 34 elastisch verformt werden, um den Eingriff der Rastnasen 42 mit den am Gehäuse 10 ausgebildeten Hinterschnitten 54 aufzuheben. Ebenfalls erkennbar sind die in den Plombierungsdurchführungen 40 angeordneten Plombierungslaschen 20.

In der in Fig. 4 dargestellten Querschnittsebene können ein Gehäuseunterteil 46 und ein Gehäuseoberteil 48 des Gehäuses 10 unterschieden werden. Gemeinsam bilden sie das geschlossene Gehäuse 10. Das Gehäuseunterteil 46 weist die Seitenwände 22 auf. An den äußeren Flächen weisen die Seitenwände 22 jeweils eine Nase 50 auf, die eine Schrägfläche 52 und einen Hinterschnitt 54 bildet. Wegen der geschlossenen Konstruktion des Gehäuses 10 sind diese Elemente vergleichsweise starr ausgebildet.

Ebenfalls in Fig. 4 erkennbar ist der Klemmendeckel 28, wobei die Schnittebene gerade durch dessen obere, die Öffnung 36 aufweisende Seitenwand führt. In dieser Ebene erkennt man die Stege 34 mit den daran ausgebildeten Rastnasen 42. Diese Elemente weisen eine relativ starke, elastische Verformbarkeit auf.

Fig. 5 zeigt eine Ausschnittsvergrößerung des linken Bereichs der Fig. 4 mit einem Steg 34 mit Rastnase 42 sowie einer Seitenwand 22 mit Schrägfläche 52 und Hinterschnitt 54. Die Schließrichtung, entlang der der Klemmendeckel 28 zum Schließen bewegt werden muss, ist in Fig. 5 durch einen Pfeil 56 veranschaulicht. Bei einer Bewegung des Klemmendeckels 28 in der Schließrichtung 56 gleitet die Rastnase 42 entlang der Schrägfläche 52, wobei die seitlichen Seitenwände 32 des Klemmendeckels 28 aufgespreizt werden, bis die Rastnasen 42 jeweils hinter einem Hinterschnitt 54 einrasten und eine selbstverriegelnde Rastverbindung mit den Hinterschnitten 54 eingehen. Wird auf den Klemmendeckel 28 eine Kraft entgegen der Schließrichtung 56 ausgeübt, kann die Verrastung dadurch nicht aufgehoben werden. Dies gelingt erst durch ein Aufspreizen des Klemmendeckels 28 durch seitliche Krafteinwirkung auf die Entriegelungsmittel bildenden Rippen 38.

### Liste der Bezugszeichen:

- 10: Gehäuse
- 12: Befestigungspunkt
- 14: Vorderseite
- 16: Anzeigeeinheit
- 18: Öffnung für Klemmschraube einer Anschlussklemme
- 20: Plombierungslasche
- 22: Seitenwand
- 24: Rippe
- 26: Führungsfläche
- 28: Klemmendeckel
- 30: Vorderwand
- 32: seitliche Seitenwand
- 34: Steg
- 36: Öffnung in oberer Seitenwand des Klemmendeckels
- 38: Rippe
- 40: Plombierungsdurchführung
- 42: Rastnase
- 44: Verriegelungsfläche
- 46: Gehäuseunterteil
- 48: Gehäuseoberteil
- 50: Nase
- 52: Schrägfläche
- 54: Hinterschnitt
- 56: Pfeil/Schließrichtung

## Patentansprüche

1. Elektrizitätszähler mit einem Gehäuse (10), Anschlussklemmen zum Anschließen an eine elektrische Versorgungsleitung und einem Klemmendeckel (28), der in einer die Anschlussklemmen abdeckenden, geschlossenen Anordnung an dem Gehäuse (10) befestigt und plombiert werden kann, wobei zwischen dem Gehäuse (10) und dem Klemmendeckel (12) eine Rastverbindung vorgesehen ist, die ein Schließen des Klemmendeckels (28) durch Bewegen des Klemmendeckels (28) in einer Schließrichtung (56) in die geschlossene Anordnung ermöglicht, wobei die Rastverbindung selbstverriegelnd ist, so dass eine auf den Klemmendeckel (28) ausgeübte Kraft in der der Schließrichtung (56) entgegengesetzten Richtung nicht zur Aufhebung der Rastverbindung führt, wobei der Klemmendeckel (28) kastenförmig mit einer Vorderwand (30), einer unteren Seitenwand und zwei sich an die untere Seitenwand anschließenden, seitlichen Seitenwänden (32), die jeweils ein freies Ende aufweisen, ausgebildet ist, **dadurch gekennzeichnet, dass** an den freien Enden jeweils ein Steg (34) mit einer Rastnase (42) angeordnet ist.

2. Elektrizitätszähler nach Anspruch 1, **dadurch gekennzeichnet, dass** der Elektrizitätszähler Entriegelungsmittel zum Aufheben der Rastverbindung aufweist.

3. Elektrizitätszähler nach Anspruch 2, **dadurch gekennzeichnet, dass** die Entriegelungsmittel dazu ausgebildet sind, beim Ausüben einer Kraft auf die Entriegelungsmittel quer zur Schließrichtung (56) eine elastische Verformung des Klemmendeckels (28) zu bewirken.

4. Elektrizitätszähler nach einem der Ansprüche 1 bis 3, **dadurch gekennzeichnet, dass** die Rastverbindung einen Hinterschnitt (54) am Gehäuse aufweist.

5. Elektrizitätszähler nach Anspruch 4, **dadurch gekennzeichnet, dass** am Hinterschnitt (54) und/oder an der Rastnase (42) eine Verriegelungsfläche (44) ausgebildet ist, die in einem Winkel im Bereich von 80° bis 100° zur Schließrichtung (56) angeordnet ist.

6. Elektrizitätszähler nach einem der Ansprüche 1 bis 5, **dadurch gekennzeichnet, dass** die Stege (34) parallel zu der unteren Seitenwand ausgerichtet sind.

7. Elektrizitätszähler nach einem der Ansprüche 1 bis 6, **dadurch gekennzeichnet, dass** an zwei Seiten des Gehäuses (10) jeweils ein Paar von parallel angeordneten Führungsflächen (26) ausgebildet ist, zwischen denen einer der Stege (34) in der Schließrichtung (56) eingeführt werden kann.

8. Elektrizitätszähler nach Anspruch 7, **dadurch gekennzeichnet, dass** der Hinterschnitt (54) zwischen den Führungsflächen (26) angeordnet ist.

9. Elektrizitätszähler nach einem der Ansprüche 2 bis 8, **dadurch gekennzeichnet, dass** die Entriegelungsmittel eine von einem der Stege (34) nach außen vorstehende Rippe (38) aufweisen.

10. Elektrizitätszähler nach einem der Ansprüche 2 bis 9, **dadurch gekennzeichnet, dass** die Entriegelungsmittel eine in einem der Stege (34) oder in einer der seitlichen Seitenwände (32) ausgebildete Öffnung aufweisen.

11. Elektrizitätszähler nach einem der Ansprüche 1 bis 10, **dadurch gekennzeichnet, dass** Plombiermittel zur Plombierung des Klemmendeckels (28) vorgesehen sind, die keinen wesentlichen Beitrag zur Fixierung des Klemmendeckels (28) in der geschlossenen Anordnung leisten.

12. Elektrizitätszähler nach einem der Ansprüche 1 bis 11, **dadurch gekennzeichnet**, zur Plombierung des Klemmendeckels (28) Öffnungen im Gehäuse (10) und im Klemmendeckel (28) ausgebildet sind, die in der geschlossenen Anordnung so zueinander ausgerichtet sind, dass ein Plombierdraht oder ein Plombierstift eingesetzt werden kann.

## Claims

1. An electricity meter with a housing (10), connection terminals for connecting to an electrical supply line, and a terminal cover (28) which can be fastened and sealed to the housing (10) in a closed arrangement covering the connection terminals, wherein a snap-fit connection is provided between the housing (10) and the terminal cover (12) and enables the terminal cover (28) to be closed by moving the terminal cover (28) into the closed arrangement in a closing direction (56), wherein the snap-fit connection is self-latching so that a force exerted on the terminal cover (28) in the direction opposite to the closing direction (56) does not lead the snap-fit connection to be released, wherein the terminal cover (28) is designed in the shape of a box with a front wall (30), a lower side wall and two lateral side walls (32) connecting to the lower side wall, each of which has a free end, **characterized in that** a web (34) with a snap-fit nose (42) is arranged on each of the free ends.

2. The electricity meter according to claim 1, **characterized in that** the electricity meter has unlatching means for releasing the snap-fit connection.

3. The electricity meter according to claim 2, **characterized in that** the unlatching means are designed to cause an elastic deformation of the terminal cover (28) when a force is exerted on the unlatching means transversely to the closing direction (56).

4. The electricity meter according to one of claims 1 to 3, **characterized in that** the snap-fit connection has an undercut (54) on the housing.

5. The electricity meter according to claim 4, **characterized in that** a latching surface (44) that is arranged at an angle in the range from 80° to 100° to the closing direction (56) is designed on the undercut (54) and/or on the snap-fit nose (42).

6. The electricity meter according to one of claims 1 to 5, **characterized in that** the webs (34) are aligned parallel to the lower side wall.

7. The electricity meter according to one of claims 1 to 6, **characterized in that** a pair of guide surfaces (26) arranged parallel are designed on each of two sides of the housing (10), between which guide surfaces one of the webs (34) can be inserted in the closing direction (56).

8. The electricity meter according to claim 7, **characterized in that** the undercut (54) is arranged between the guide surfaces (26).

9. The electricity meter according to one of claims 2 to 8, **characterized in that** the unlatching means have a rib (38) projecting outwards from one of the webs (34).

10. The electricity meter according to one of claims 2 to 9, **characterized in that** the unlatching means have an opening designed in one of the webs (34) or in one of the lateral side walls (32).

11. The electricity meter according to one of claims 1 to 10, **characterized in that** sealing means for sealing the terminal cover (28) are provided, which make no significant contribution to fixing the terminal cover (28) in the closed state.

12. The electricity meter according to one of claims 1 to 11, **characterized in that** openings are designed in the housing (10) and in the terminal cover (28) for sealing the terminal cover (28), which openings are aligned with each other in the closed arrangement such that a sealing wire or a sealing pin can be introduced.

## Revendications

1. Compteur d'électricité doté d'un boîtier (10), de bornes de connexion pour la connexion à une ligne d'alimentation électrique et d'un cache-bornes (28) apte à être fixé et scellé au boîtier (10) dans une configuration fermée recouvrant les bornes de connexion, dans lequel une liaison à encliquetage est prévue entre le boîtier (10) et le cache-bornes (12), laquelle permet une fermeture du cache-bornes (28) par déplacement du cache-bornes (28) dans une direction de fermeture (56) vers la configuration fermée, dans lequel la liaison à encliquetage se verrouille automatiquement, de sorte qu'une force exercée sur le cache-bornes (28) dans la direction opposée à la direction de fermeture (56) n'entraîne pas la rupture de la liaison à encliquetage, dans lequel le cache-bornes (28) est conçu en forme de caisson avec une paroi avant (30), une paroi latérale inférieure et deux parois latérales de côté (32) se raccordant à la paroi latérale inférieure, lesquelles présentent respectivement une extrémité libre, **caractérisé en ce qu'**une âme (34) dotée d'un nez d'encliquetage (42) est disposée respectivement aux extrémités libres.

2. Compteur d'électricité selon la revendication 1, **caractérisé en ce que** le compteur d'électricité présente des moyens de déverrouillage pour la rupture de la liaison à encliquetage.

3. Compteur d'électricité selon la revendication 2, **caractérisé en ce que** les moyens de déverrouillage sont conçus pour générer une déformation élastique du cache-bornes (28) perpendiculairement à la direction de fermeture (56) lors de l'exercice d'une force sur les moyens de déverrouillage.

4. Compteur d'électricité selon l'une des revendications 1 à 3, **caractérisé en ce que** la liaison à encliquetage présente une contre-dépouille (54) sur le boîtier.

5. Compteur d'électricité selon la revendication 4, **caractérisé en ce qu'**une surface de verrouillage (44) disposée selon un angle dans la plage de 80° à 100° par rapport à la direction de fermeture (56) est formée sur la contre-dépouille (54) et/ou sur le nez d'encliquetage (42).

6. Compteur d'électricité selon l'une des revendications 1 à 5, **caractérisé en ce que** les âmes (34) sont orientées parallèlement à la paroi latérale inférieure.

7. Compteur d'électricité selon l'une des revendications 1 à 6, **caractérisé en ce qu'**une paire de surfaces de guidage (26) disposées parallèlement, entre lesquelles l'une des âmes (34) peut être insérée dans la direction de fermeture (56), est formée sur deux côtés du boîtier (10).

8. Compteur d'électricité selon la revendication 7, **caractérisé en ce que** la contre-dépouille (54) est disposée entre les surfaces de guidage (26).

9. Compteur d'électricité selon l'une des revendications 2 à 8, **caractérisé en ce que** les moyens de déverrouillage présentent une nervure (38) faisant saillie vers l'extérieur à partir de l'une des âmes (34).

10. Compteur d'électricité selon l'une des revendications 2 à 9, **caractérisé en ce que** les moyens de déverrouillage présentent une ouverture formée dans l'une des âmes (34) ou dans l'une des parois latérales de côté (32).

11. Compteur d'électricité selon l'une des revendications 1 à 10, **caractérisé en ce qu'**il est prévu des moyens de scellement destinés au scellement du cache-bornes (28), lesquels ne contribuent pas substantiellement à la fixation du cache-bornes (28) dans la configuration fermée.

12. Compteur d'électricité selon l'une des revendications 1 à 11, **caractérisé en ce que** pour le scellement du cache-bornes (28), des ouvertures orientées de telle façon les unes par rapport aux autres dans la configuration fermée qu'un fil de scellement ou une tige de scellement peut être inséré(e) sont formées dans le boîtier (10) et dans le cache-bornes (28).
